# EUROPEAN PATENT SPECIFICATION

(11) **EP 4 273 091 B1**
(45) Date of publication and mention of the grant of the patent: **03.06.2026**
(21) Application number: 23167983.8
(22) Date of filing: 14.04.2023
(51) Int. Cl.: B81B 3/00, B81C 1/00

(54) **MEMS STRUCTURE INCLUDING A BURIED CAVITY WITH ANTISTICTION PROTUBERANCES, AND MANUFACTURING METHODS THEREOF**
MEMS-STRUKTUR MIT EINEM VERGRABENEN HOHLRAUM MIT ANTIHAFTUNGSVORSPRÜNGEN UND HERSTELLUNGSVERFAHREN DAFÜR
STRUCTURE MEMS COMPRENANT UNE CAVITÉ ENTERRÉE À PLOTS ANTI-FROTTEMENT STATIQUE ET SES PROCÉDÉS DE FABRICATION

(30) Priority: 02.05.2022 IT 202200008822
(43) Date of publication of application: 08.11.2023
(73) Proprietor: STMicroelectronics S.r.l., 20864 Agrate Brianza (MB) (IT)
(72) Inventor: AZPEITIA URQUIA, Mikel, 20128 MILANO (IT); DUQI, Enri, 20147 MILANO (IT); NICOLI, Silvia, 20836 BRIOSCO (MB) (IT); CAMPEDELLI, Roberto, 20026 NOVATE MILANESE (MI) (IT); VARISCO, Igor, 20019 SETTIMO MILANESE (MI) (IT); TENTORI, Lorenzo, 20843 VERANO BRIANZA (MB) (IT)
(74) Representative: Studio Torta S.p.A.

(56) References cited:
- EP-A1- 3 845 485
- EP-A2- 2 075 224
- US-A1- 2005 181 529
- US-A1- 2021 285 983

## Description

The present disclosure relates to a micromechanical or microelectromechanical structure, to manufacturing methods thereof, and to a MEMS transducer; in particular, this structure includes a buried cavity having one or more antistiction bumps extending therein.

As known, integrated pressure sensors may be provided with micromanufacturing techniques. These sensors typically comprise a thin membrane, or diaphragm, suspended above a cavity obtained in a semiconductor body. Piezoresistive elements connected to each other are formed within the membrane and connected in a Wheatstone bridge. When subject to a pressure, the membrane undergoes a deformation, causing a variation in the resistance of the piezoresistive elements, and therefore an imbalance of the Wheatstone bridge. Alternatively, capacitive sensors are available, wherein the membrane provides a first plate of a capacitor, while a second plate is provided by a fixed reference. In use, the deflection of the membrane generates a variation in the capacitance of the capacitor, which may be detected and associated with the pressure exerted on the membrane.

A significant defect, which occurs in particular conditions in micromechanical devices, is the irreversible stiction of the movable structures with a fixed element adjacent thereto, or to the substrate. It is apparent that this phenomenon may entail serious consequences, up to making the MEMS systems affected thereby inoperative, in an unpredictable way. In particular, in case of a membrane, the stiction of the membrane to the substrate on which the membrane is suspended makes it unusable.

The stiction phenomenon is typically generated by the surface forces that are exerted between the surfaces of two bodies coming into contact. Of course, the wider the contact zone, the greater the interaction force between the surfaces. In addition, further factors that are to be considered in assessing and preventing stiction are, inter alia, the roughness of the surfaces, their wear, the level of humidity and the temperature of the environment wherein the micromechanical structures operate. These parameters are particularly difficult to monitor in case of membranes suspended on buried cavities, due to the inherent difficulty of operating internally to these buried cavities to reduce the causes of stiction.

A possible solution lies in the stiffening of the membrane, so that it never reaches the full stroke during use and no direct contact occurs between the opposite surfaces delimiting the cavity having the membrane suspended thereon. For example, it is possible to increase the stiffness of the membrane by increasing the thickness of the membrane. In manufacturing processes of known semiconductor pressure sensors, the membrane is formed by an epitaxial growth. The increase in the epitaxial growth time, necessary to obtain a thicker membrane, has several drawbacks such as, for example, an increase in costs and an increase in the non-uniformity of the rear side of the semiconductor wafer, which cause difficulties in handling the wafer and incompatibility problems with subsequent steps of the manufacturing process. Furthermore, the known integrated semiconductor pressure sensors are typically designed and used to measure relatively low pressures (for example up to 0.1 MPa), and a stiffening of the membrane thereof might cause an operating difficulty at such pressures.

EP2075224 relates to the field of micromechanical and/or nanomechanical devices comprising mobile elements, and more particularly that of microelectromechanical systems (MEMS) and/or nanoelectromechanical systems (NEMS) comprising mobile elements capable of coming into contact with other elements of the MEMS and/or NEMS during its operation.

US 2021/285983 relates to a physical quantity sensor, an electronic apparatus, and a vehicle.

US 2005/181529 relates to a method for manufacturing a semiconductor component.

EP3845485 relates to the field of temperature sensor, and in particular to a manufacturing method for a temperature sensor, the method comprising a step of forming a plurality of trenches with varying spacing on a silicon wafer and a thermal annealing step.

However, the above-mentioned issues are not solved.

The aim of the present invention is to provide a manufacturing method of a structure as defined in claim 1 for overcoming the drawbacks of the prior art.

For a better understanding of the present invention, preferred embodiments thereof are now described, purely by way of non-limiting example, with reference to the attached drawings, wherein:
- Figure 1 illustrates, in lateral sectional view, a micromechanical structure formed by a manufacturing method according to an embodiment of the present invention;
- Figures 2A-2E illustrate steps of a manufacturing process of the micromechanical structure of Figure 1;
- Figure 3 illustrates, in lateral sectional view, a further micromechanical structure formed by the manufacturing method according to an embodiment of the present invention;
- Figures 4A-4E illustrate steps of a manufacturing process of the micromechanical structure of Figure 3;
- Figures 5A-5C illustrate, in plan view, a layout of the micromechanical structure of Figure 3 in an intermediate manufacturing step;
- Figures 6A-6G illustrate steps of a manufacturing process of the micromechanical structure of Figure 1 or Figure 3 according to a further embodiment of the present invention;
- Figures 7A-7C illustrate a manufacturing method of the micromechanical structure of Figure 1 or Figure 3 according to a further embodiment of the present invention; and
- Figures 8A and 8B illustrate a variant of the manufacturing method of Figures 7A-7C.

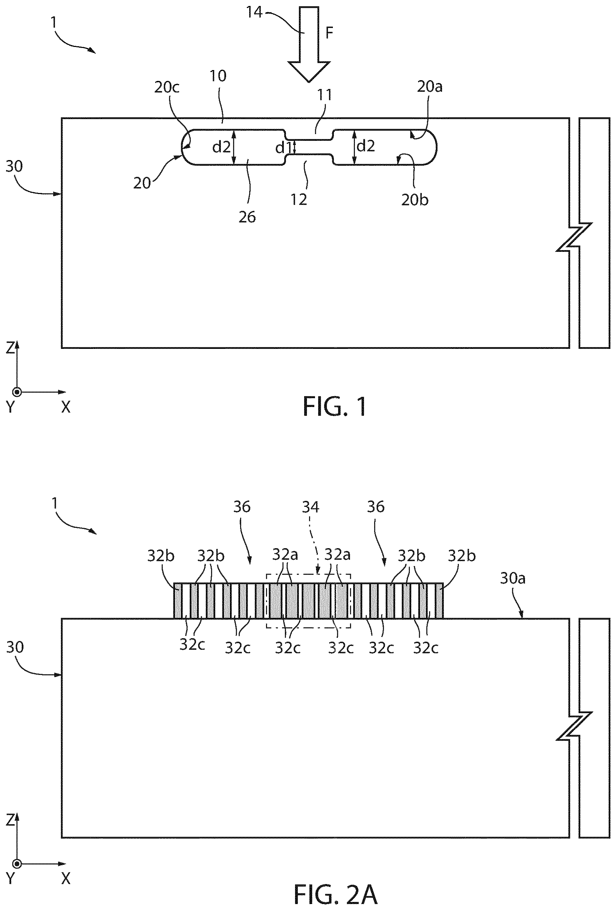

Figure 1 illustrates, in a triaxial system of X, Y, Z axes orthogonal to each other, a portion of a semiconductor wafer 1 including a micromechanical or microelectromechanical (MEMS) structure. However, it is apparent that what has been described applies similarly to a portion of a semiconductor wafer, for example to a die. Similarly, at the end of the processing steps of the wafer, this may be diced ("dicing" operation) to isolate a plurality of dies or chips.

The wafer 1, or die, comprises a semiconductor body 30 which accommodates a membrane 10 suspended on a cavity 20 buried in the semiconductor body 30. The cavity 20 is delimited upwardly by a top side (or wall) 20a (which is part of the membrane 10) and downwardly by a bottom side (or wall) 20b (which is part of the semiconductor body 30), opposite to the top side 20a along the Z axis. Lateral sides (or walls) 20c physically connect the top side 20a with the bottom side 20b.

In one embodiment, the membrane 10 extends, at rest, substantially parallel to the XY plane. It is however possible to design the membrane 10 having internal stresses such that the membrane 10 extends, at rest, not perfectly parallel to the XY plane, but with a concave or convex shape. In the following of the present description and in the Figures it is assumed, for simplicity of description and representation, that the membrane 10 is parallel to the XY plane.

The cavity 20 has one or more protrusions, or protuberances, or "bumps", 11 which extend from the top side 20a towards the bottom side 20b, and vice versa, one or more protrusions, or protuberances, or "bumps", 12 which extend from the bottom side 20b towards the top side 20a. For sake of simplicity, Figure 1 illustrates a single bump 11 and a single bump 12.

In a further embodiment, not illustrated, one of the bump 11 and the bump 12 may be omitted.

The membrane 10 is therefore partially suspended on the cavity 20 and is for bending when a suitable external force F is applied along the direction Z as identified by the arrow 14. At rest, when no external force F acts on the membrane 10, the membrane 10 is substantially parallel to the XY plane. In the presence of a suitable force F, the membrane 10 bends, and, as the force F increases, the membrane 10 bends up to a maximum bending wherein the bumps 11, 12 are in mutual contact.

The bumps 11, 12 operate, in this context, as antistiction structures, minimizing the risk of irreversible stiction between the opposite sides 20a, 20b internal to the cavity 20 when, during use, the sides 20a, 20b come close to each other. In fact, according to the present invention, the contact occurs exclusively between the bumps 11, 12 which have a reduced contact surface and, therefore, also the stiction forces are consequently reduced.

With reference to Figures 2A-2E, a manufacturing method according to an embodiment of the invention of the membrane 10 on the buried cavity 20 in the semiconductor body 30 is described.

The wafer 1 is, in particular, of monocrystalline silicon; the wafer 1 may be N-type or P-type doped (the type of doping is not relevant for the present invention, and may be defined during the design step according to the specific application wherein the present technical solution is intended to operate).

As previously noted, reference will be made hereinafter to the processing of a wafer; however, what has been described applies similarly to the processing of portions of a semiconductor wafer, for example a die. Similarly, at the end of the processing steps of the wafer 1, this may be diced ("dicing" operation) to isolate a plurality of dies or chips manufactured simultaneously as described herein.

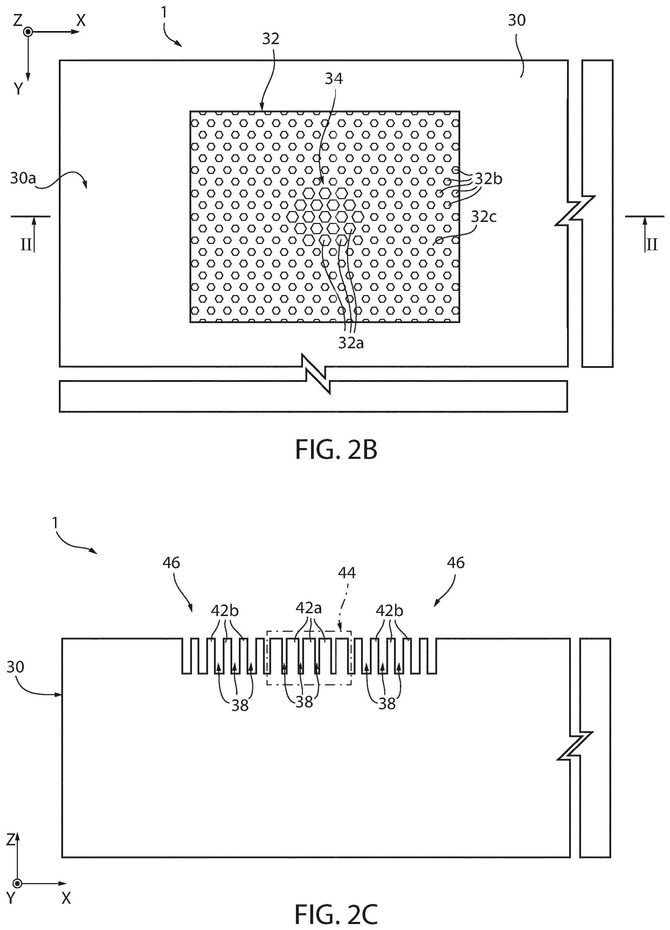

With joint reference to Figure 2A (in lateral sectional view) and to Figure 2B (in XY plane top view), the wafer 1 comprises the semiconductor body 30 (possibly previously processed, as needed, for example including a monocrystalline silicon epitaxial layer grown on a monocrystalline silicon substrate). The view of Figure 2A is along section line II-II of Figure 2B.

A photoresist mask 32 is provided above a top surface 30a of the semiconductor body 30 by a photolithography step. The mask 32 is formed at regions of the semiconductor body 30 wherein it is desired to form the buried cavity 20 and, consequently, the membrane 10 suspended thereon.

The mask 32 defines a honeycomb lattice, having first mask regions 32a and second mask regions 32b, for example of hexagonal shape in XY plane top view, close to each other and separated from each other by through openings 32c extending through the entire thickness of the mask 32.

In particular, the first and the second mask regions 32a, 32b are regions wherein the photoresist material is physically present ("full" regions); the through openings 32c are regions wherein the photoresist material has been removed ("empty" regions) by the photolithographic process, having the top surface 30a of the semiconductor body 30 exposed therethrough.

The first mask regions 32a have, in top view, a first value of base area; the second mask regions 32b have, in top view, a second value of base area, lower than the first value of base area.

In other words, according to an aspect of the present invention, the mask 32 has portions 34, 36 with full/empty ratio different from each other. The portion 34 comprises exclusively the first mask regions 32a and, in the portion 34, the full/empty ratio has a first value (e.g., of the order of 4). Therefore, inside the portion 34, all the first mask regions 32a have the same value of base area (unless there are variations depending on the tolerances of the same process).

Similarly, the portion 36 comprises exclusively the second mask regions 32b and, in the portion 36, the full/empty ratio has a second value (e.g., of the order of 2) which is lower than the first value. Within the portion 36, all the second mask regions 32b have the same value of base area (unless there are variations depending on the tolerances of the same process).

By way of example, in the portion 34, the first mask regions 32a have, as said, hexagonal shape in plan view and diameter (both along the X and Y axis) in the range 2.2-2.6 µm, and are separated from each other by a gap 32c having extension (both along the X and Y axis) in the range 0.4-0.8 µm. In the portion 36, the second mask regions 32b have a hexagonal shape and diameter (both along the X and Y axis) in the range 1.8-2.1 µm, and are separated from each other by a gap 32c having extension (both along the X and Y axis) in the range 0.9-1.2 µm.

By using the mask 32, Figure 2C, an etching of the semiconductor body 30 is performed, forming trenches 38 having depths, along the Z axis, of a few micrometers, for example depth comprised between 0.5 µm and 50 µm. The trenches 38 define columns 42a, 42b of silicon, having a shape corresponding to the shape of the honeycomb regions defined by the mask 32.

Therefore, portions 44, 46 corresponding to the portions 34, 36 of the mask 32 are defined also in the semiconductor body 30; the portion 44 comprises the silicon columns 42a which have shape, dimensions and mutual distance uniform to each other; similarly the portion 46 comprises the silicon columns 42b which have shape, dimensions and mutual distance uniform to each other and different with respect to the portion 44.

Each column 42a has, in the portion 44, shape and dimensions defined by the portion 34 of the mask 32, for example a hexagonal shape in XY plane plan view, and a diameter equal to about 2.4 µm, and is separated from an adjacent column, along X and along Y, by about 0.6 µm.

Each column 42b has, in the portion 46, shape and dimensions defined by the portion 36 of the mask 32, for example a hexagonal shape in XY plane plan view, and a diameter equal to about 2 µm, and is separated from an adjacent column, along X and along Y, by about 1 µm.

In other words, each column 42a has a base area (on the XY plane) which is different from the base area (on the XY plane) of each column 42b. The base area (on the XY plane) of the columns 42a is greater than the base area (on the XY plane) of the columns 42b.

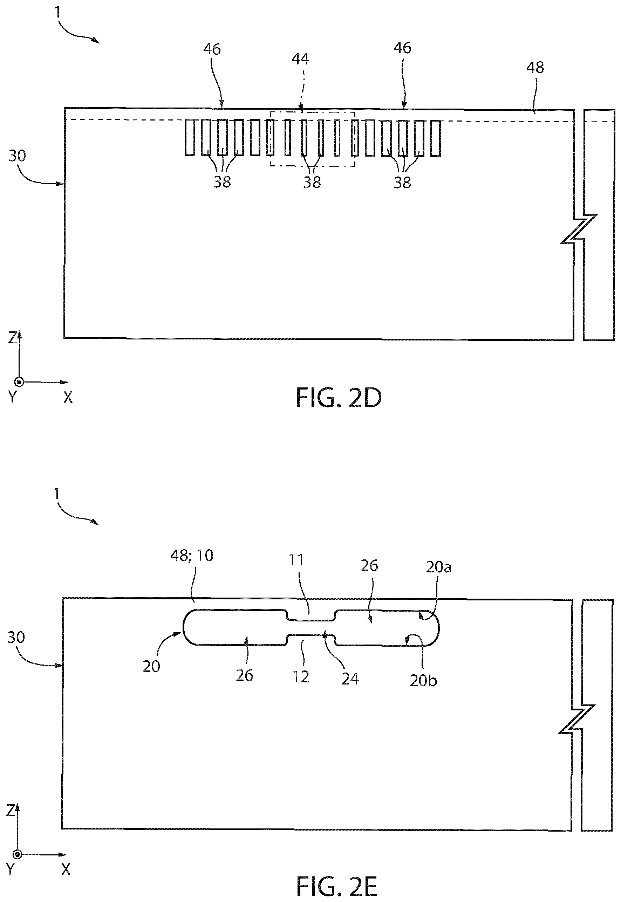

In general, the mutual spacing of the columns 42a, 42b is designed of such a value as to allow a top closure of the trenches 38 during the epitaxial growth step described with reference to Figure 2D.

After the formation of the columns 42a, 42b, the mask 32 is removed.

With reference to Figure 2D, an epitaxial growth is performed in a deoxidizing environment (typically, in an atmosphere having a high concentration of hydrogen, preferably using trichlorosilane-SiHCl₃). The epitaxial growth is performed at least until the trenches 38 are closed upwardly (for example, for 45 seconds at a temperature close to 1200°C).

Consequently, an epitaxial layer 48 grows above the silicon columns 42a, 42b, closes the trenches 38 upwardly and traps therein the gas present (here, molecules of hydrogen H₂).

An annealing step is then performed, for example for about 30-40 minutes at a temperature of about 1190-1200°C. The annealing step causes, Figure 2E, a migration of the silicon atoms which tend to move to the lower energy position, in a per se known manner, as for example discussed in the article by T. Sato, N. Aoki, I. Mizushima and Y. Tsunashima, "A New Substrate Engineering for the Formation of Empty Space in Silicon (ESS) Induced by Silicon Surface Migration", IEDM 1999, pp. 517-520.

At the trenches 38, where the silicon columns are close to each other, the silicon atoms migrate and form the cavity 20 closed upwardly by the epitaxial layer 48 (which, now, forms the membrane 10).

Preferably, the annealing is performed in an H₂ atmosphere so as to prevent the hydrogen present in the trenches 38 from escaping through the epitaxial layer towards the outside and to increase the concentration of hydrogen present in the cavity 20 if that trapped during the epitaxial growth step were not sufficient. Alternatively, the annealing may be carried out in a nitrogen environment.

The different shape and mutual distance between the silicon columns, in the portions 44 and 46 of the semiconductor body 30, entails that the migration of the atoms during the annealing step of Figure 2E causes the formation of the cavity 20 as described with reference to Figure 1, i.e. it leads to the formation of the bumps 11 and 12.

In practice, forming the buried cavity 20 comprises concurrently forming different types of cavities, or sub-cavities, joined to each other and in mutual connection. A first type of sub-cavity 24 is formed at the portion 44 and has a maximum extension, along the Z axis, lower than the maximum extension, again along the Z axis, of a second type of sub-cavity 26 which is formed at the portion 46. The sub-cavities 24 and 26 are in connection to each other and their typological division is qualitative and not clear-cut. According to the present invention, at the sub-cavity 24, the bumps 11, 12 are formed which tend to partially occlude, or locally narrow, the buried cavity 20.

The Applicant has verified the formation of the first bump 11 at the side 20a that delimits the cavity 20 upwardly, and of the second bump 12 at the side 20b that delimits the cavity 20 downwardly as a direct consequence of the different mutual arrangement and dimension of the silicon columns 42a, 42b and corresponding trenches 38 separating them. Where the silicon columns have a greater base area and are closer to each other (i.e., at the silicon columns 42a) there is formed the sub-cavity 24, with dimension d₁ along the Z axis reduced due to the presence of the bumps 11, 12; where the silicon columns have a smaller base area and are more spaced from each other (i.e., at the silicon columns 42b), there is formed the sub-cavity 26, with dimension d₂ along the Z axis greater than the corresponding dimension d₁ of the sub-cavity 24, as it has no bumps 11, 12.

For example, it is d₁=1.5-2 µm and d₂=2.1-2.5 µm.

Although the Figures illustrate, for sake of simplicity, bumps 11, 12 having the same thickness along the Z axis, the advantageous effect of the present invention would be obtained even if (by variation in the process parameters) a bump protruded from the respective side for a maximum thickness, along Z, greater than the corresponding maximum thickness of the other bump. Similarly, one of the bumps 11 and 12 might not be present.

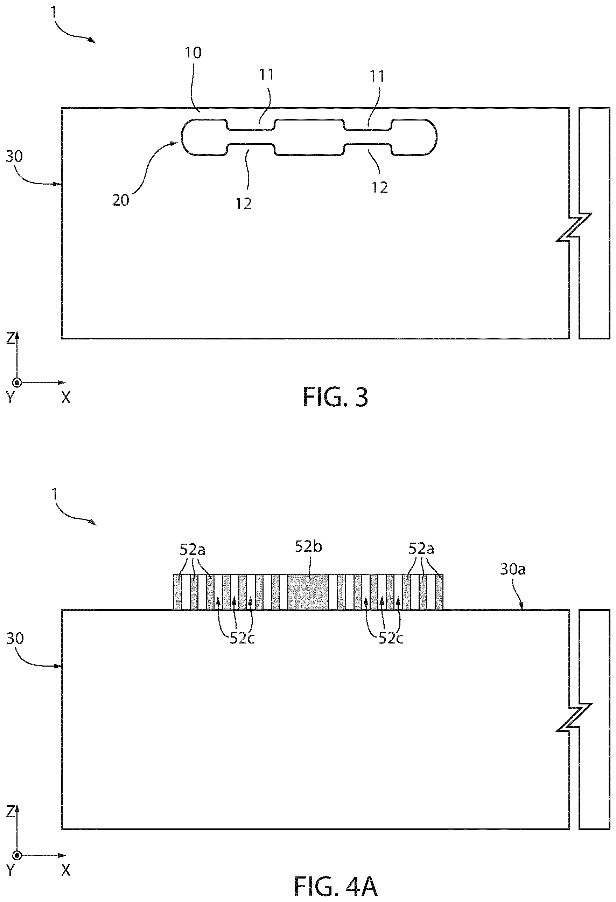

Figure 3 illustrates the semiconductor body 30 including the membrane 10 and the cavity 20, wherein the cavity 20 accommodated therein a plurality of bumps 11 (at the top side 20a) and a plurality of bumps 12 (at the bottom side 20b). In this embodiment, the bumps 11 and 12 are formed as described with reference to Figures 2A-2E.

Figures 4A-4E illustrate a method for manufacturing the wafer 1 of Figure 1, in particular for forming the bumps 11, 12, according to an alternative embodiment with respect to that of Figures 2A-2E. As previously noted, what has been described applies similarly to the processing of a die. At the end of the processing steps of the wafer 1, this may be diced to isolate a plurality of dies or chips manufactured simultaneously as described herein.

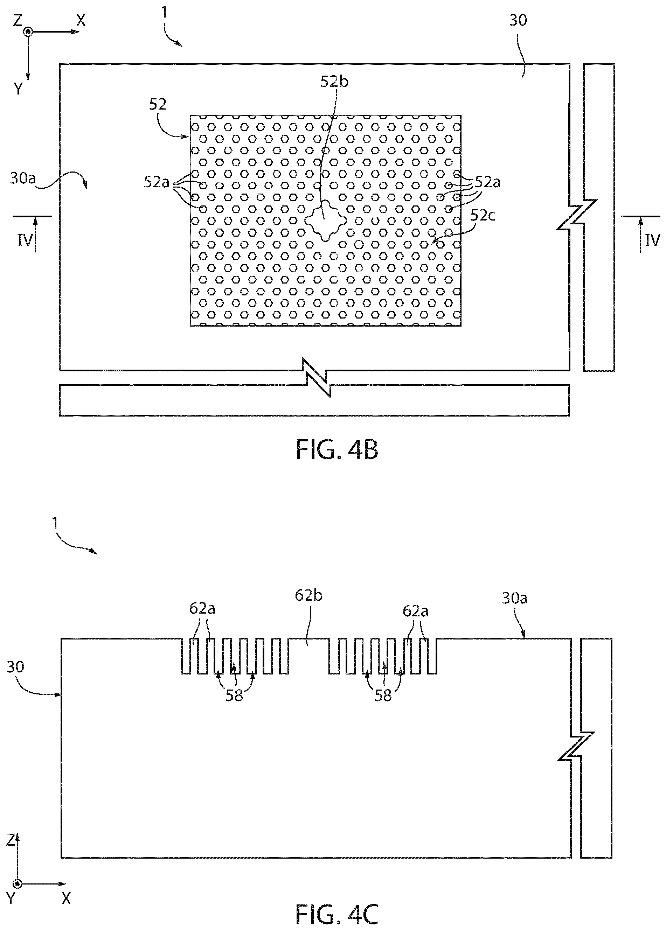

With joint reference to Figure 4A (in lateral sectional view) and to Figure 4B (in XY plane top view), the wafer 1 comprises the semiconductor body 30 (possibly previously processed, as needed, for example including a monocrystalline silicon epitaxial layer grown on a monocrystalline silicon substrate). The view of Figure 4A is along section line IV-IV of Figure 4B.

A photoresist mask 52 is provided above the top surface 30a of the semiconductor body 30 by a photolithography step. The mask 52 is formed at regions of the semiconductor body 30 wherein it is desired to form the buried cavity 20 and, consequently, the membrane 10 suspended thereon.

The mask 52 defines a honeycomb lattice, having mask regions 52a for example of hexagonal shape, close to each other and separated from each other by through openings 52c extending through the entire thickness of the mask 52. A second mask region 52b has no through openings 52c.

In particular, the first and the second mask regions 52a, 52b are regions wherein the photoresist material is physically present ("full" regions); the through openings 52c are regions wherein the photoresist material has been removed ("empty" regions) by the photolithographic process, having the top surface 30a of the semiconductor body 30 exposed therethrough.

The first mask regions 52a have, in top view, a first value of base area; the second mask region 52b has, in top view, a second value of base area, greater than the first value of base area.

In other words, according to an aspect of the present invention, the portion of the mask 52 wherein the first mask regions 52a are present has a full/empty ratio of the type already described for the portion 36 of the mask 52 of Figure 2A or 2B. The portion of the mask 52 wherein the second mask region 52b is present has no empty spaces.

By way of example, the first mask regions 52a have a hexagonal shape and diameter (both along the X and Y axis) in the range 1.8-2.1 µm, and are separated from each other by a gap 32c having extension (both along the X and Y axis) in the range 0.9-1.2 µm.

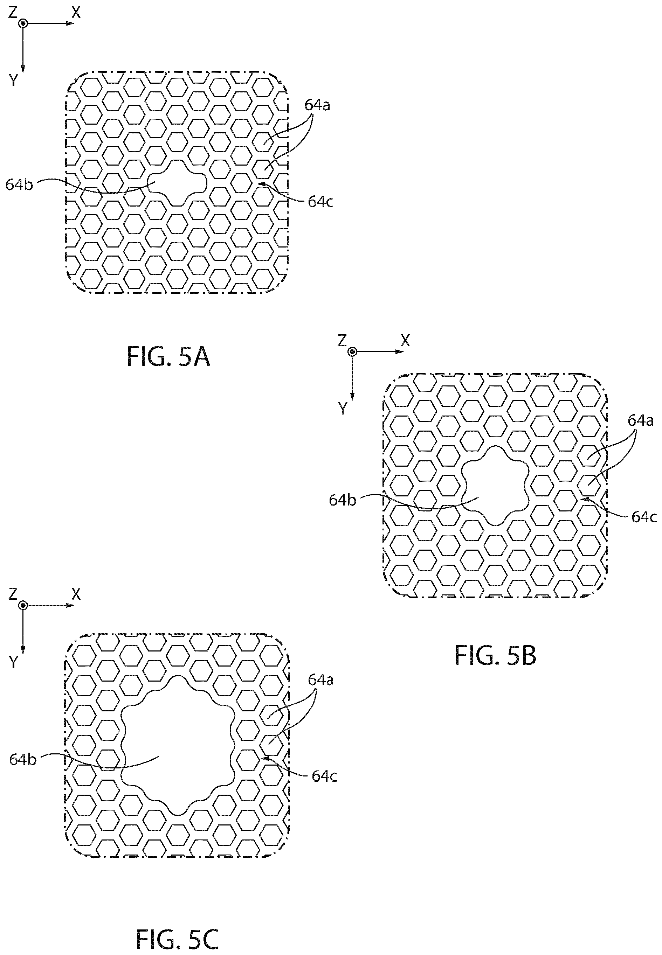

The second mask region 52b has any shape (e.g. generically polygonal), chosen during the design step, for example of the type illustrated in Figures 5A-5C according to the respective embodiments.

By using the mask 52, Figure 4C, an etching of the semiconductor body 30 is performed, forming trenches 58 having depths, along the Z axis, of a few micrometers, for example depth comprised between 0.5 µm and 50 µm. The trenches 58 define columns 62a, 62b of silicon having a shape corresponding to the shape of the regions 52a, 52b defined by the mask 52. Therefore, also in the semiconductor body 30 silicon columns 62a are formed which have shape, dimensions and mutual distance uniform to each other, as determined by the first mask region 52a; similarly, a single silicon column 62b is formed, contiguous to the silicon columns 62a (in particular, surrounded by the silicon columns 62a, at a distance determined by the trenches 58), which has a shape and dimensions defined by the second mask region 52b.

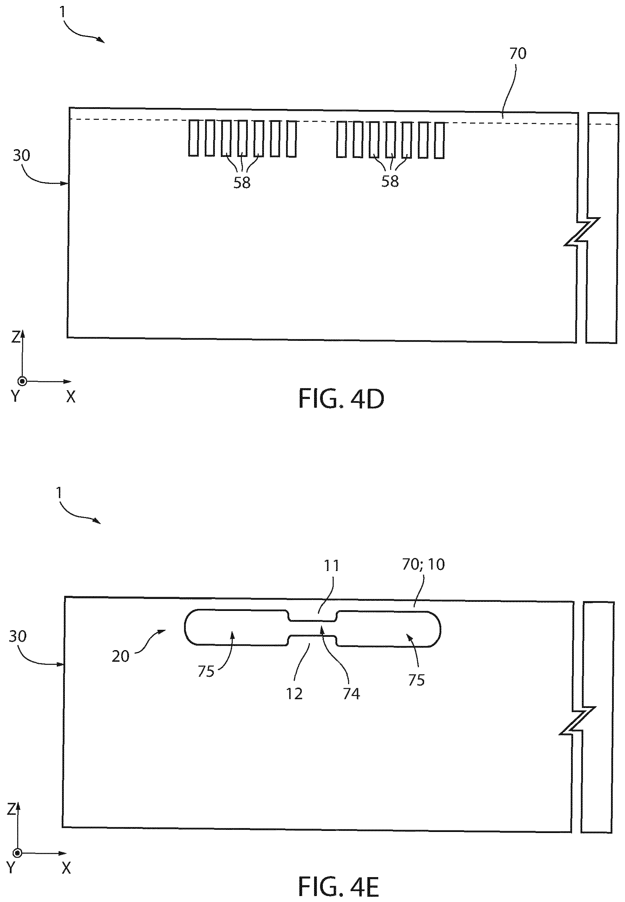

Each column 62a has, for example, a hexagonal shape with a diameter equal to about 2 µm, and is separated from an adjacent column 62a, along X and along Y, by about 1 µm. In general, diameter and spacing of the columns 62a are designed of such a value as to allow a top closure of the trenches 58 during the epitaxial growth step described with reference to Figure 4D.

After the formation of the columns 62a, 62b, the mask 52 is removed.

With reference to Figure 4D, an epitaxial growth is performed in a deoxidizing environment (typically, in an atmosphere having a high concentration of hydrogen, preferably using trichlorosilane-SiHCl₃). The epitaxial growth is performed at least until the trenches 58 are closed upwardly (for example, for 45 seconds at a temperature close to 1200°C).

Consequently, an epitaxial layer 70 grows above the silicon columns 62a, 62b, closes the trenches 58 upwardly and traps therein the gas present (here, molecules of hydrogen H₂).

An annealing step is then performed, for example for about 30-40 minutes at a temperature of about 1190-1200°C. The annealing step causes, Figure 4E, a migration of the silicon atoms which tend to move to the lower energy position, in a per se known manner, as for example discussed in the article by T. Sato, N. Aoki, I. Mizushima and Y. Tsunashima, "A New Substrate Engineering for the Formation of Empty Space in Silicon (ESS) Induced by Silicon Surface Migration", IEDM 1999, pp. 517-520.

At the trenches 58, where the silicon columns are close to each other, the silicon atoms migrate and form the cavity 20 closed upwardly by the epitaxial layer 70 (which, now, forms the membrane 10).

Preferably, the annealing is performed in an H₂ atmosphere so as to prevent the hydrogen present in the trenches 58 from escaping through the epitaxial layer towards the outside and to increase the concentration of hydrogen present in the cavity 20 if that trapped during the epitaxial growth step were not sufficient. Alternatively, the annealing may be carried out in a nitrogen environment.

The mutual distance between the silicon columns 62a, and the distance between the silicon columns 62a and the silicon column 62b, entails that the migration of the atoms during the annealing step of Figure 4E shapes the cavity 20 in analogy to what has been described with reference to Figure 1, i.e. leads to the formation of the bumps 11 and 12.

Similarly to what has been previously observed, forming the buried cavity 20 comprises concurrently forming different types of cavities, or sub-cavities, joined to each other and in mutual connection. A first type of sub-cavity 74 is formed at the silicon column 62b, and a second type of sub-cavity 75 is formed at the silicon columns 62a. The sub-cavity 74 of the first type has a maximum extension, along the Z axis, lower than the maximum extension, along the Z axis, of the second type of sub-cavity 75. The typological division among the sub-cavities of different type is qualitative and not clear-cut. According to the present invention, the bumps 11, 12 are formed at the sub-cavity 74 of the first type and tend to partially occlude, or locally narrow, the buried cavity 20.

Although Figure 4E illustrates, for simplicity of representation, bumps 11, 12 having the same thickness along the Z axis, the advantageous effect of the present invention would be obtained even if (by variation in the process parameters) one of the bumps 11, 12 protruded from the respective side for a maximum thickness, along Z, greater than the corresponding maximum thickness of the other bump 11, 12. Similarly, one of the bumps 11 and 12 might be absent.

Figure 5A illustrates, in XY plane view, a layout of the column, or pillar, 62b. In this embodiment, the column 62b has the shape of a four-pointed "star" or of a "cross", of maximum dimension (from tip to tip), along X and along Y equal to a few micrometers, for example 7 µm along the X axis and 5 µm along the Y axis.

Figure 5B illustrates, in XY plane view, a further layout of the column, or pillar, 62b. In this embodiment, the column 62b has the shape of a six-pointed "star", and for example maximum dimension (from tip to tip), along Y equal for example to 8 µm and minimum dimension, along X, equal for example to 6 µm.

Figure 5C illustrates, in XY plane view, a further layout of the column, or pillar, 62b. In this embodiment, the column 62b has the shape of a twelve-pointed "star" or "flower", and the maximum dimension (from tip to tip), along X or along Y, comprised for example between 12 and 14 µm.

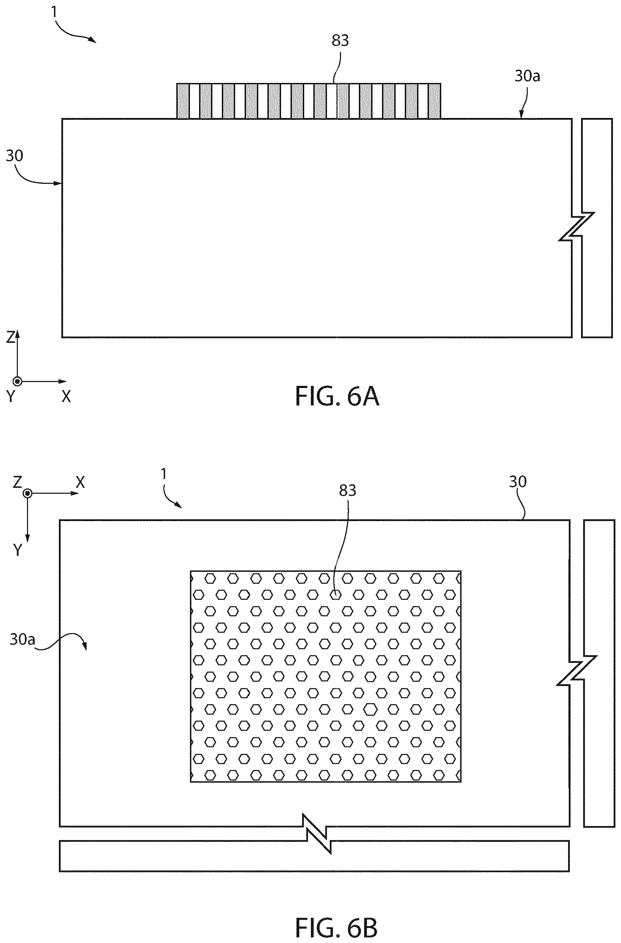

Figures 6A-6G illustrate a manufacturing method of the wafer 1, in particular of the membrane 10 suspended on the buried cavity 20 which includes at least the bump 11, according to a further embodiment of the present invention. As previously noted, what has been described applies similarly to the processing of a die. At the end of the processing steps of the wafer 1, this may be diced to isolate a plurality of dies or chips manufactured simultaneously as described herein.

With joint reference to Figure 6A (in lateral sectional view) and to Figure 6B (in top view), the wafer 1 comprises the semiconductor body 30, here of monocrystalline silicon. A photoresist mask 83 is provided above the top surface 30a of the semiconductor body 30 by a photolithography step. The mask 83 is formed at regions of the semiconductor body 30 wherein it is desired to form the cavity 20.

The mask 83 defines a honeycomb lattice, having mask regions, for example of a hexagonal shape, close to each other.

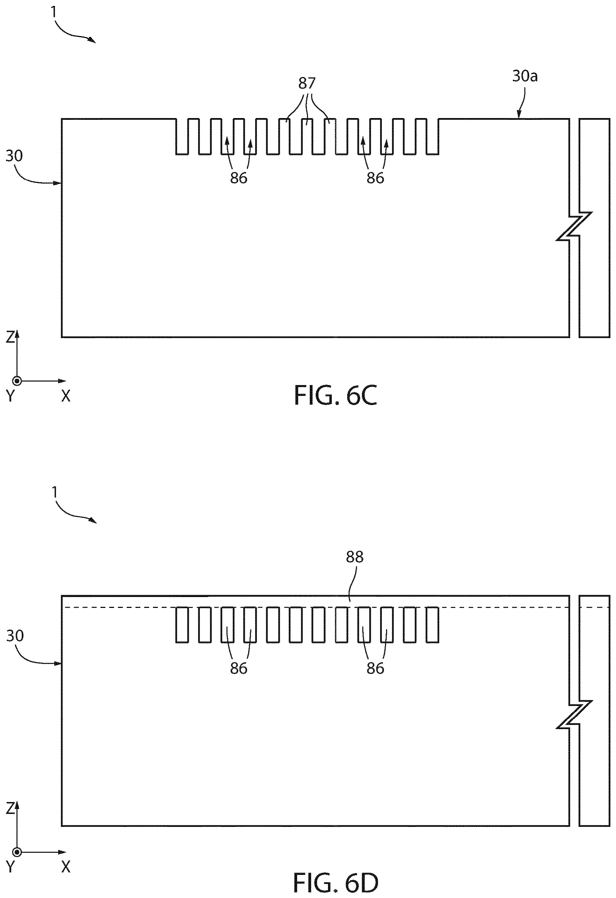

By using the mask 83, Figure 6C, an etching of the semiconductor body 30 is performed, forming trenches 86 having depths of a few micrometers, for example comprised between 5 µm and 25 µm. The trenches 86 define silicon columns 87 substantially equal to each other and of a shape corresponding to the shape of the honeycomb regions defined by the mask 83. Exemplarily, each column 87 has a diameter equal to about 1 µm and is separated from an adjacent column, along X or along Y, by about 1 µm. In general, diameter and spacing of the columns 87 are chosen of such a value as to allow a top closure of the trenches 86 during the epitaxial growth step described hereinbelow.

Subsequently, Figure 6D, the mask 83 is removed and an epitaxial growth is performed in a deoxidizing environment (typically, in an atmosphere having a high concentration of hydrogen, preferably using trichlorosilane-SiHCl₃). The epitaxial growth is performed at least until the trenches 86 are closed upwardly (for example, for 45 seconds at a temperature close to 1200°C).

Consequently, a sealing layer 88 (hereinafter forming, at least in part, the membrane 10), is grown epitaxially above the silicon columns 87; the sealing layer 88 closes the trenches 86 upwardly and traps therein the gas present (here, molecules of hydrogen H₂).

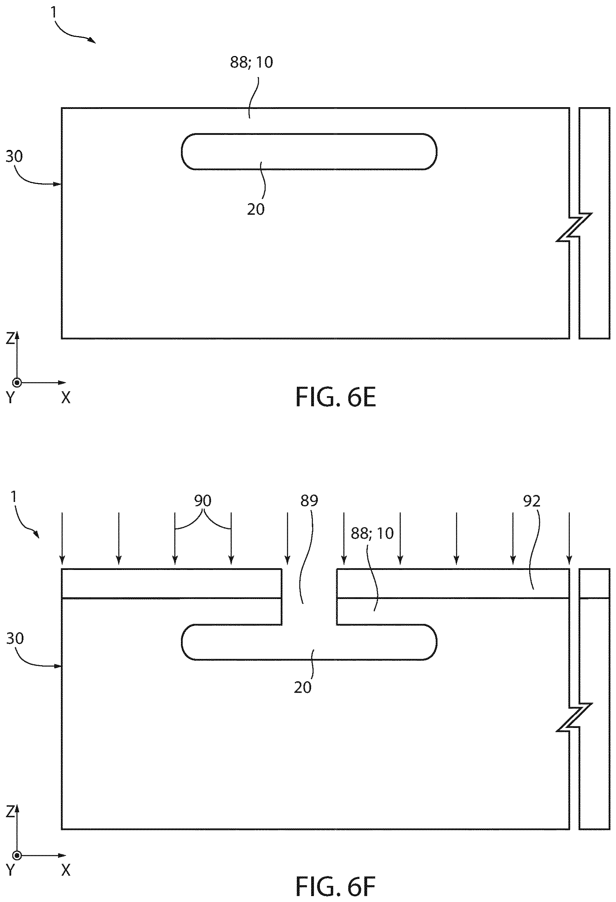

An annealing step is then performed, for example for about 30-40 minutes at a temperature of about 1190-1200°C. The annealing step causes, Figure 6E, a migration of the silicon atoms which tend to move to the lower energy position, in a per se known manner, as for example discussed in the article by T. Sato, N. Aoki, I. Mizushima and Y. Tsunashima, "A New Substrate Engineering for the Formation of Empty Space in Silicon (ESS) Induced by Silicon Surface Migration", IEDM 1999, pp. 517-520.

At the trenches 86, where the silicon columns are close to each other, the silicon atoms migrate completely and form the cavity 20, closed upwardly by the sealing layer 88, of Silicon.

Preferably, the annealing is performed in an H₂ atmosphere so as to prevent the hydrogen present in the trenches 86 from escaping through the epitaxial layer towards the outside and to increase the concentration of hydrogen present in the cavity 20 if that trapped during the epitaxial growth step were not sufficient. Alternatively, the annealing may be carried out in a nitrogen environment.

Then, Figure 6F, the sealing layer 88 is selectively removed at a portion thereof wherein the bump 11 is intended to be formed. To this end, a chemical etching (arrows 90 in Figure 6F) is performed using an etching mask 92 to form an opening 89 passing through the entire thickness of the sealing layer 88. The through opening 89 reaches the cavity 20, putting it in connection with the external environment.

The through opening 89 has, for example, a circular or generically polygonal shape in XY plane view, for example with a diameter comprised between 0.1 and 5 µm, more particularly between 0.1 and 1 µm, even more particularly between 0.1 and 0.3 µm. The through opening 89 may also have irregular shapes, or for example one of the shapes and dimensions illustrated in Figures 5A-5C for the element 62b.

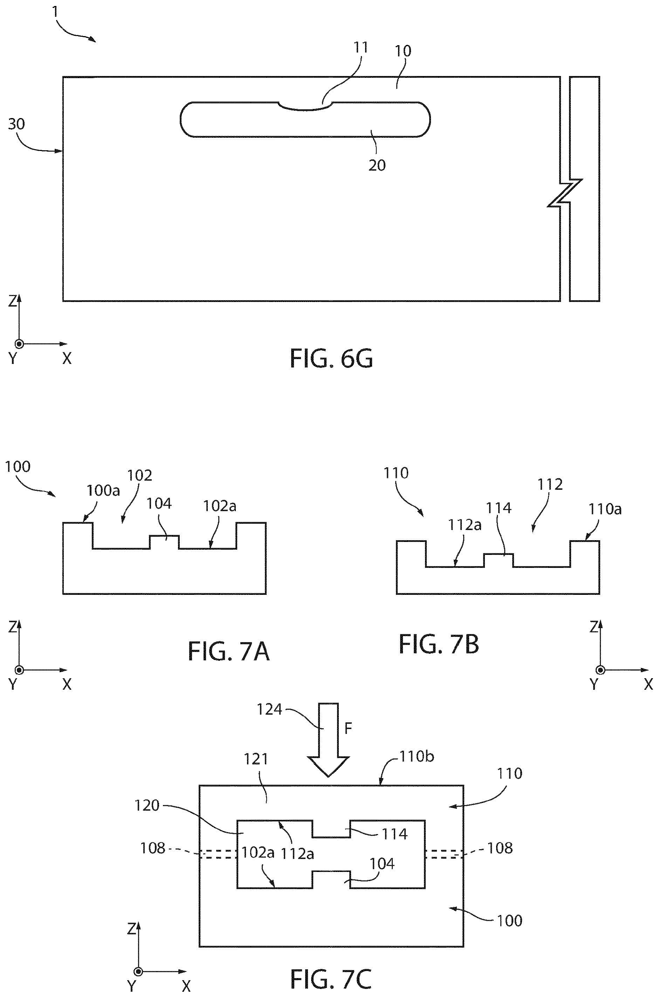

Then, Figure 6G, an epitaxial growth step is performed at the sealing layer 88, such that it closes the through opening 89 thus isolating the cavity 20 from the external environment. In an initial step of the epitaxial growth, the Silicon also grows epitaxially towards the inside of the cavity 20, at the through opening 89, forming a protuberance that extends towards the inside of the cavity 20. By continuing the epitaxial growth, the through opening 89 closes and this protuberance forms the bump 11. The cavity 20, at the end of the method, is buried in the semiconductor body 30 and its internal pressure is defined by the pressure present in the reaction chamber during the epitaxial growth leading to the formation of the bump 11.

By forming a plurality of through openings similar to the through opening 89 it is possible to form a respective plurality of bumps.

The membrane 10 may be thinned, if necessary, for example by CMP technique.

Figures 7A-7C illustrate a further technical solution for manufacturing a buried cavity provided with one or more bumps. Figures 7A-7C are illustrated in a triaxial reference system of X, Y, Z axes orthogonal to each other. Reference will be made hereinafter to the processing of wafers; however, what has been described applies similarly to the processing of portions of a semiconductor wafer, for example dies. Similarly, at the end of the processing steps of the wafers, these may be diced ("dicing" operation) to isolate a plurality of dies or chips manufactured simultaneously as described herein.

With reference to Figure 7A, a first wafer 100 of semiconductor material, for example of Silicon, is shaped so as to form, at one front side 100a thereof, a recess 102 having a bottom side 102a. The bottom side 102a has a protuberance, or bump, 104, for example having a circular, polygonal or irregular shape, which extends moving away from the bottom side 102a. The bump 104 may have one of the shapes described and illustrated with reference to Figures 5A-5C for the element 62b. The bump 104 extends, from the bottom side 102a, for a height, along the Z axis, comprised between 0.01 and 1 µm (in particular between 0.1 and 1 µm).

With reference to Figure 7B, a second wafer 110 of semiconductor material is arranged, having a front side 112a and a rear side 110b opposite to each other along the Z axis. The second wafer 110 is for example of Silicon. The second wafer 110 is shaped so as to form, at the front side 112a, a recess 112 having a bottom side 112a. The bottom side 112a has a protuberance, or bump, 114, for example having a circular, polygonal or irregular shape. The bump 114 may have one of the shapes described and illustrated with reference to Figures 5A-5C for the element 62b. The bump 114 extends, from the bottom side 112a, for a height, along the Z axis, comprised between 0.01 and 1 µm (in particular between 0.1 and 1 µm).

The bumps 104 and 114 are formed in such a way that, when the first and the second wafers 100, 110 are coupled to each other as described with reference to Figure 7C, the bumps 104 and 114 are at least partially aligned with each other along the direction of the Z axis.

Then, Figure 7C, the first wafer 100 and the second wafer 110 are coupled to each other at coupling regions 108 extending laterally to (i.e., surrounding) the recesses 102, 112. The coupling may be carried out by per se known wafer-to-wafer bonding techniques. For example, it is possible to use glue, double-sided adhesive layers, glass frit, etc. The coupling between the wafers 100, 110 is performed in such a way that the recesses 102, 112 form, together, a cavity 120 fluidically isolated from the external environment.

The second wafer 110 thus forms, at its rear side 110b, a membrane 121 suspended on the cavity 120. It is possible to thin the second wafer 110 at the rear side 110b to obtain a desired thickness for the membrane 121.

The membrane 121 is for bending when a suitable external force F is applied along the Z direction as identified by arrow 124. At rest, when no external force F acts on the membrane 121, the membrane 121 is substantially parallel to the XY plane. In the presence of a suitable force F, the membrane 121 bends, and, as the force F increases, the membrane 121 bends up to a maximum bending point wherein the bumps 104, 114 are in mutual contact.

The bumps 104, 114 operate, in this context, as antistiction structures, minimizing the risk of irreversible stiction between the opposite sides 102a, 112a internal to the cavity 120 when, during use, the opposite sides 102a, 112a come close to each other. In fact, according to the present invention, the contact occurs exclusively between the bumps 104, 114 which have a reduced contact surface and, therefore, also the stiction forces are consequently reduced.

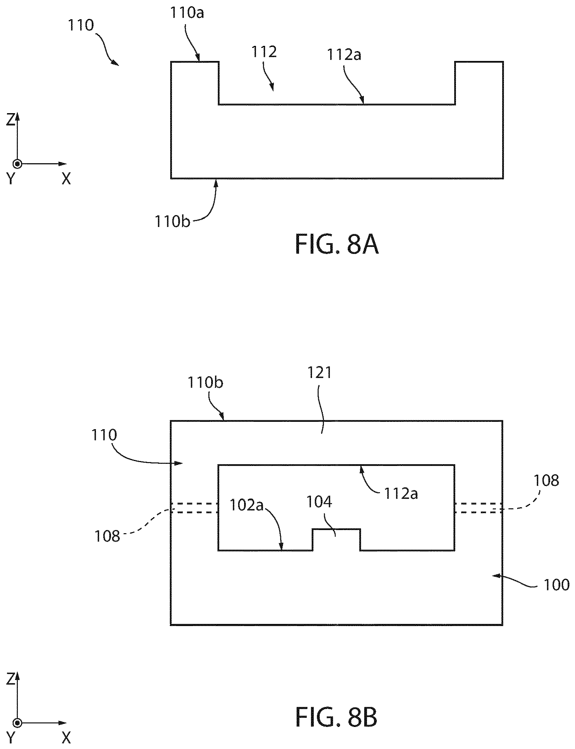

In a further embodiment illustrated in Figures 8A and 8B (where elements common to Figures 7A-7C are illustrated with the same reference numbers and are not further described), the second wafer 110 is shaped so as not to have the bump 114. In this case, when the first and the second wafers 100, 110 are coupled to each other (Figure 8B), for example according to the previously described techniques, the cavity 120 accommodates the sole bump 104.

It is apparent that, according to further embodiments, not illustrated, one of or both the first and the second wafers 100, 110 may be shaped so as to have a plurality of bumps 104 and/or a plurality of bumps 114, with shapes and dimensions equal to or different from each other.

The present invention, regardless of the embodiment, may find application as a pressure sensor (in particular of differential type), or as a fluidic micro-valve or fluidic micro-pump with an actuation that is, in particular, piezoelectric.

The transduction of the signal applied on the membrane 10, 110 (force F) may occur according to any of the known techniques, for example by forming piezoresistors on the membrane 10, 110, or in proximity thereto, in a manner known per se and not an object of the present invention. In particular, for providing a piezoelectric-type pressure sensor it is sufficient, during the final manufacturing steps, for example while providing the components of the control circuitry, to provide piezoresistive elements in proximity of the periphery of the same membrane 10, 121. Preferably, the piezoresistive elements have P-type conductivity and the membrane has N-type conductivity (the electrical conductivities are obtained by implanting dopant species, in a per se known manner). Alternatively, the piezoresistors may be made of polysilicon above the membrane.

The embodiment of Figures 7A-7C, or 8A-8B, is suitable for manufacturing a capacitive pressure sensor, using coupling regions 108 which electrically insulate the two wafers 100, 110 which form the two electrons, or plates, of a capacitor. By applying a pressure on the membrane 121, it deflects, reducing its distance from the bottom electrode (wafer 100). As a result, the capacitance of the sensing capacitor increases. By measuring this capacitance variation, an indication of the applied pressure (force F) is obtained.

From an examination of the characteristics of the invention described and illustrated herein, the advantages that it affords are evident.

In particular, the present invention allows antistiction structures to be provided inside a buried cavity, maintaining a desired pressure (defined during the design step) of the cavity. In particular, the cavity has an internal pressure lower than the atmospheric pressure wherein the structure thus formed is designed to operate.

Finally, it is clear that modifications and variations may be made to the invention described and illustrated herein without thereby departing from the scope of the present invention, as defined in the attached claims.

For example, the layout of the buried cavity 20, 120 according to any embodiment described may be freely designed according to parameters that are not an object of the present invention. By way of non-limiting example, the buried cavity 20, 120 may have, in XY plane plan view, a shape chosen from quadrangular, circular, quadrangular with rounded edges, polygonal, irregular.

Furthermore, the hexagonal or honeycomb shape of the base area 8 (in XY plane view) of the columnar structures 42a, 42b (similarly, 62a, 62b) may be different, i.e. generically polygonal or circular.

Furthermore, the shape of the columnar structures 42a, 42b (similarly, 62a, 62b) may further vary; for example they may be replaced by septa of semiconductor material, or in general by other thin structures capable of allowing the migration of silicon during the annealing step, favoring or allowing the formation of the buried cavity.

## Claims

1. A method for manufacturing a structure, comprising the steps of:
forming, at a first surface region of a semiconductor body, first columnar portions (42a; 62a) having a first value of base area and separated from each other by first trenches (38; 58);
forming, at a second surface region of the semiconductor body, contiguous to said first surface region, at least one second columnar portion (42b; 62b) having a second value of base area different from the first value of base area;
epitaxially growing, above said first and second columnar portions (42a, 42b; 62a, 62b) and said first trenches (38), a membrane layer (48; 10) of semiconductor material;
performing an annealing such that it causes the migration of the semiconductor material of said first and second columnar portions (42a, 42b; 62a, 62b) concurrently forming:
a buried cavity (20) in the semiconductor body (30) below the membrane layer (48; 10), internally delimited by a top wall (20a; 112a), a bottom wall (20b; 102b) which is opposite to the top wall along a direction (Z), and lateral walls (20c) which connect the top wall with the bottom wall; and
at least one first antistiction bump (11; 104) completely contained in the cavity (20) and which protrudes from one of the top wall (20a; 112a) and the bottom wall (20b; 102b) along said direction (Z).

2. The method according to claim 1, further comprising forming, at the second surface region of the semiconductor body, further second columnar portions (42b) having the second dimension of base area, mutually separated by second trenches (38),
wherein the step of epitaxially growing the membrane layer (48; 10) includes sealing said first and second trenches (38) upwardly.

3. The method according to claim 2, wherein the first columnar portions and the first trenches define, at the first surface region, a first full/empty ratio of said semiconductor material,
and wherein the second columnar portions and the second trenches define, at the second surface region, a second full/empty ratio of said semiconductor material,
the value of the first full/empty ratio being lower than the value of the second full/empty ratio.

4. The method according to anyone of claims 1-3, wherein the second value of base area is greater than the first value of base area.

5. The method according to anyone of claims 2-4, wherein, along a cross-section of said semiconductor body (30), the first trenches (38) have a greater dimension than the second trenches (38) and the second columnar portions (42b) have a greater dimension than the first columnar portions (42a).

6. The method according to anyone of claims 1-4, wherein, along a cross-section of said semiconductor body (30), said at least one second columnar portion (42b; 62b) has a greater dimension than each of the first columnar portions (42a; 62a).

7. The method according to anyone of claims 1-6, wherein said first columnar portions (42a; 62a) and said at least one second columnar portion (42b; 62b) have a polygonal section on a plane orthogonal to said direction (Z).

8. The method according to anyone of claims 1-7, wherein performing the annealing further forms concurrently at least one second antistiction bump (12; 114) completely contained in the cavity (20) and which protrudes along said direction (Z) from the other of the top wall (20a; 112a) and the bottom wall (20b; 102b) which accommodates the first antistiction bump (11; 104).

9. The method according to anyone of claims 1-8, wherein the semiconductor body (30), the membrane layer and the first antistiction bump (11; 104) and the second antistiction bump (12; 114) are of monocrystalline Silicon.

10. The method according to anyone of claims 1-9, wherein the first antistiction bump (11; 104) and the second antistiction bump (12; 114) have a respective thickness, along the direction (Z), comprised between 0.01 and 1 µm.

11. The method according to anyone of claims 1-10, wherein said step of performing an annealing is performed in a deoxidizing environment.

## Patentansprüche

1. Verfahren zum Herstellen einer Struktur, das die folgenden Schritte umfasst:
Bilden, an einem ersten Oberflächenbereich eines Halbleiterkörpers, erster Säulenabschnitte (42a; 62a), die einen ersten Wert der Grundfläche aufweisen und durch erste Gräben (38; 58) voneinander getrennt sind;
Bilden, an einem zweiten Oberflächenbereich des Halbleiterkörpers, der an den ersten Oberflächenbereich angrenzend ist, mindestens eines zweiten Säulenabschnitts (42b; 62b), der einen zweiten Wert der Grundfläche aufweist, der sich von dem ersten Wert der Grundfläche unterscheidet; epitaxiales Aufwachsen einer Membranschicht (48; 10) aus Halbleitermaterial oberhalb der ersten und zweiten Säulenabschnitte (42a, 42b; 62a, 62b) und der ersten Gräben (38) ;
Durchführen eines Glühens, so dass es die Migration des Halbleitermaterials der ersten und zweiten Säulenabschnitte (42a, 42b; 62a, 62b) bewirkt, wodurch gleichzeitig Folgendes gebildet wird:
ein vergrabener Hohlraum (20) in dem Halbleiterkörper (30) unterhalb der Membranschicht (48; 10), der innen durch eine Oberwand (20a; 112a), eine Unterwand (20b; 102b), die der Oberwand entlang einer Richtung (Z) gegenüberliegt, und Seitenwände (20c), die die Oberwand mit der Unterwand verbinden, begrenzt ist; und
mindestens ein erster Anti-Haftvorsprung (11; 104), der vollständig in dem Hohlraum (20) enthalten ist und der von einer der Oberwand (20a; 112a) und der Unterwand (20b; 102b) entlang der Richtung (Z) vorsteht.

2. Verfahren nach Anspruch 1, ferner umfassend das Bilden, an dem zweiten Oberflächenbereich des Halbleiterkörpers, weiterer zweiter Säulenabschnitte (42b), die die zweite Abmessung der Grundfläche aufweisen und die durch zweite Gräben (38) voneinander getrennt sind,
wobei der Schritt des epitaxialen Aufwachsens der Membranschicht (48; 10) das Verschließen der ersten und zweiten Gräben (38) nach oben enthält.

3. Verfahren nach Anspruch 2, wobei die ersten Säulenabschnitte und die ersten Gräben an dem ersten Oberflächenbereich ein erstes Voll-/Leer-Verhältnis des Halbleitermaterials definieren,
und wobei die zweiten Säulenabschnitte und die zweiten Gräben an dem zweiten Oberflächenbereich ein zweites Voll-/Leer-Verhältnis des Halbleitermaterials definieren,
wobei der Wert des ersten Voll-/Leer-Verhältnisses niedriger ist als der Wert des zweiten Voll-/Leer-Verhältnisses.

4. Verfahren nach einem der Ansprüche 1 bis 3, wobei der zweite Wert der Grundfläche größer ist als der erste Wert der Grundfläche.

5. Verfahren nach einem der Ansprüche 2 bis 4, wobei die ersten Gräben (38) entlang eines Querschnitts des Halbleiterkörpers (30) eine größere Abmessung aufweisen als die zweiten Gräben (38) und die zweiten Säulenabschnitte (42b) eine größere Abmessung aufweisen als die ersten Säulenabschnitte (42a).

6. Verfahren nach einem der Ansprüche 1 bis 4, wobei der mindestens eine zweite Säulenabschnitt (42b; 62b) entlang eines Querschnitts des Halbleiterkörpers (30) eine größere Abmessung aufweist als jeder der ersten Säulenabschnitte (42a; 62a).

7. Verfahren nach einem der Ansprüche 1 bis 6, wobei die ersten Säulenabschnitte (42a; 62a) und der mindestens eine zweite Säulenabschnitt (42b; 62b) einen polygonalen Querschnitt auf einer Ebene aufweisen, die orthogonal zu der Richtung (Z) ist.

8. Verfahren nach einem der Ansprüche 1 bis 7, wobei das Durchführen des Glühens gleichzeitig mindestens einen zweiten Anti-Haftvorsprung (12; 114) bildet, der vollständig in dem Hohlraum (20) enthalten ist und der entlang der Richtung (Z) von der anderen der Oberwand (20a; 112a) und der Unterwand (20b; 102b) vorsteht, die den ersten Anti-Haftvorsprung (11; 104) aufnimmt.

9. Verfahren nach einem der Ansprüche 1 bis 8, wobei der Halbleiterkörper (30), die Membranschicht und der erste Anti-Haftvorsprung (11; 104) und der zweite Anti-Haftvorsprung (12; 114) aus monokristallinem Silizium bestehen.

10. Verfahren nach einem der Ansprüche 1 bis 9, wobei der erste Anti-Haftvorsprung (11; 104) und der zweite Anti-Haftvorsprung (12; 114) entlang der Richtung (Z) eine jeweilige Dicke zwischen 0,01 und 1 µm aufweisen.

11. Verfahren nach einem der Ansprüche 1 bis 10, wobei der Schritt des Durchführens eines Glühens in einer desoxidierenden Umgebung durchgeführt wird.

## Revendications

1. Procédé de fabrication d'une structure, comprenant les étapes suivantes :
former, dans une première région de surface d'un corps de semiconducteur, des premières parties colonnaires (42a ; 62a) ayant une première valeur de surface au sol et séparées les unes des autres par des premières tranchées (38 ; 58) ;
former, dans une deuxième région de surface du corps de semiconducteur, contiguë à ladite première région de surface, au moins une deuxième partie colonnaire (42b ; 62b) ayant une deuxième valeur de surface au sol, différente de la première valeur de surface au sol ;
former par croissance épitaxiale, au-dessus desdites premières et deuxièmes parties colonnaires (42a, 42b ; 62a, 62b) et desdites premières tranchées (38), une couche de membrane (48 ; 10) en matériau semiconducteur ;
réaliser un recuit de manière à provoquer la migration du matériau semiconducteur desdites premières et deuxièmes parties colonnaires (42a, 42b ; 62a, 62b) formant simultanément :
une cavité enfouie (20) dans le corps de semiconducteur (30) sous la couche de membrane (48 ; 10), délimitée intérieurement par une paroi supérieure (20a ; 112a), une paroi inférieure (20b ; 102b) qui est en face de la paroi supérieure le long d'une direction (Z), et des parois latérales (20c) qui relient la paroi supérieure à la paroi inférieure ; et
au moins une première bosse antifriction (11 ; 104) contenue entièrement dans la cavité (20) et qui fait saillie depuis l'une des parois supérieure (20a ; 112a) et paroi inférieure (20b ; 102b) le long de ladite direction (Z).

2. Procédé selon la revendication 1, comprenant en outre le fait de former, dans la deuxième région de surface du corps de semiconducteur, des deuxièmes parties colonnaires supplémentaires (42b) ayant la deuxième dimension de surface au sol, séparées mutuellement par des deuxièmes tranchées (38),
dans lequel l'étape de croissance épitaxiale de la couche de membrane (48 ; 10) comprend le fait de fermer lesdites premières et deuxième tranchées (38) vers le haut.

3. Procédé selon la revendication 2, dans lequel les premières parties colonnaires et les première tranchées définissent, dans la première région de surface, un premier rapport plein/vide dudit matériau semiconducteur,
et dans lequel les deuxièmes parties colonnaires et les deuxièmes tranchées définissent, dans la deuxième région de surface, un deuxième rapport plein/vide dudit matériau semiconducteur,
la valeur du premier rapport plein/vide étant inférieure à la valeur du deuxième rapport plein/vide.

4. Procédé selon l'une quelconque des revendications 1 à 3, dans lequel la deuxième valeur de surface au sol est plus grande que la première valeur de surface au sol.

5. Procédé selon l'une quelconque des revendications 2 à 4, dans lequel, le long d'une section transversale dudit corps de semiconducteur (30), les premières tranchées (38) ont une plus grande dimension que les deuxièmes tranchées (38) et les deuxièmes parties colonnaires (42b) ont une plus grande dimension que les premières parties colonnaires (42a).

6. Procédé selon l'une quelconque des revendications 1 à 4, dans lequel, le long d'une section transversale dudit corps de semiconducteur (30), ladite au moins une deuxième partie colonnaire (42b ; 62b) a une plus grande dimension que chacune des premières parties colonnaires (42a ; 62a).

7. Procédé selon l'une quelconque des revendications 1 à 6, dans lequel lesdites premières parties colonnaires (42a ; 62a) et ladite au moins une deuxième partie colonnaire (42b ; 62b) sont de section polygonale sur un plan orthogonal à ladite direction (Z).

8. Procédé selon l'une quelconque des revendications 1 à 7, dans lequel la réalisation du recuit forme aussi simultanément au moins une deuxième bosse antifriction (12 ; 114) contenue entièrement dans la cavité (20) et qui fait saillie le long de ladite direction (Z) depuis l'autre paroi parmi la paroi supérieure (20a ; 112a) et la paroi inférieure (20b ; 102b) qui comporte la première bosse antifriction (11 ; 104).

9. Procédé selon l'une quelconque des revendications 1 à 8, dans lequel le corps de semiconducteur (30), la couche de membrane et la première bosse antifriction (11 ; 104) et la deuxième bosse antifriction (12 ; 114) sont en silicium monocristallin.

10. Procédé selon l'une quelconque des revendications 1 à 9, dans lequel la première bosse antifriction (11 ; 104) et la deuxième bosse antifriction (12 ; 114) ont une épaisseur respective, dans la direction (Z), comprise entre 0,01 et 1 µm.

11. Procédé selon l'une quelconque des revendications 1 à 10, dans lequel ladite étape de réalisation d'un recuit est exécutée dans un environnement désoxydant.
